# EUROPEAN PATENT APPLICATION

(11) **EP 4 525 004 A1**
(43) Date of publication of application: **19.03.2025**
(21) Application number: 23819732.1
(22) Date of filing: 31.05.2023
(51) Int. Cl.: H01F 1/28

(54) **COMPOUND, MOLDED BODY AND CURED PRODUCT**

(30) Priority: 09.06.2022 WO PCT/JP2022/023340
(71) Applicant: Resonac Corporation, Tokyo 105-7325 (JP)
(72) Inventor: SONOKAWA, Hiroki, Tokyo 105-7325 (JP); ENDO, Yoshinori, Tokyo 105-7325 (JP); INABA, Yoshihito, Tokyo 105-7325 (JP); TAKAHASHI, Hiroyuki, Tokyo 105-7325 (JP)
(74) Representative: Hoffmann Eitle
(86) International application number: PCT/JP2023/020295
(87) International publication number: WO 2023/238752

(57) **Abstract**

A compound contains a first soft magnetic powder, a second soft magnetic powder, and a resin composition. The resin composition contains a thermosetting resin. The particle diameter of the first soft magnetic powder is greater than the particle diameter of the second soft magnetic powder. First soft magnetic particles composing the first soft magnetic powder include a metal portion, and an insulating coating film directly covering the metal portion. At least a part of the metal portion is a soft magnetic alloy containing Fe, Cr, and Si. The insulating coating film contains SiO₂. The content of Fe₂O₃ is 0% by atom or more and 10% by atom or less in a surface region of the first soft magnetic particles where a depth from the outermost surface of the first soft magnetic particles is 100 nm or less.

## Description

### Technical Field

The present disclosure relates to a compound, a molded body, and a cured product.

### Background Art

A compound containing a soft magnetic powder and a thermosetting resin is used as a raw material for various industrial products required to have soft magnetic characteristics (refer to Patent Literatures 1 to 3 described below). For example, the compound is used as a raw material for an inductor, a transformer, a reactor, a thyristor valve, a noise filter (an EMI filter), a choke coil, an iron core for a motor, a rotor and a yoke of a motor used for general household electrical appliances and industrial appliances, an electromagnetic shield, a solenoid core (a fixed iron core) for an electromagnetic valve, and the like.

### Citation List

### Patent Literature

Patent Literature 1: Japanese Unexamined Patent Publication No. 2009-94428
Patent Literature 2: Japanese Unexamined Patent Publication No. 2019-104954
Patent Literature 3: International Publication WO 2020/217476

### Summary of Invention

### Technical Problem

Pure iron or an iron-based alloy used as the soft magnetic powder of the related art has not only the soft magnetic characteristics (a comparatively high relative magnetic permeability or the like) but also electrical conduction properties. Therefore, the compound of the related art containing the soft magnetic powder does not have sufficient electrical insulating properties (a dielectric withstanding voltage or the like). As the content of the soft magnetic powder in the compound increases, the soft magnetic characteristics increase, but the electrical insulating properties are degraded. The electrical insulating properties of the compound are improved by physically attaching glass to the surface of the soft magnetic powder (soft magnetic particles) in accordance with a mechano-fusion method or the like. Alternatively, the electrical insulating properties of the compound are improved by forming a coating film consisting of a phosphate or a phosphosilicate on the surface of the soft magnetic powder (the soft magnetic particles). However, since there is a tendency that the soft magnetic characteristics are degraded as the electrical insulating properties are improved, it is difficult to make the soft magnetic characteristics and the electrical insulating properties compatible. Further, the mechanical strength (for example, a bending strength) of a cured product of the compound of the related art is likely to decrease under a high-temperature and humidity environment.

In order to apply the compound containing the soft magnetic powder to various industrial products, it is desirable to improve the soft magnetic characteristics and the electrical insulating properties of the compound.

An object of one aspect of the present invention is to provide a compound excellent in soft magnetic characteristics and electrical insulating properties, a molded body containing the compound, and a cured product of the compound.

### Solution to Problem

For example, one aspect of the present invention relates to [1] to [14] described below.
[1] A compound containing:
   a first soft magnetic powder;
   a second soft magnetic powder; and
   a resin composition,
   wherein the resin composition contains a thermosetting resin,
   a particle diameter of the first soft magnetic powder is greater than a particle diameter of the second soft magnetic powder,
   first soft magnetic particles composing the first soft magnetic powder include a metal portion, and an insulating coating film directly covering the metal portion,
   at least a part of the metal portion is a soft magnetic alloy containing iron, chromium, and silicon,
   the insulating coating film contains SiO₂, and
   a content of Fe₂O₃ in a surface region of the first soft magnetic particles where a depth from an outermost surface of the first soft magnetic particles is 100 nm or less is 0% by atom or more and 10% by atom or less.
[2] The compound according to 1],
   wherein a lowest melt viscosity of the compound at 175°C is 10 Pa·s or more and 250 Pa·s or less, and
   a spiral flow of the compound at 175°C is 30 cm or more and 200 cm or less.
[3] The compound according to [1] or [2],
   wherein the compound fluidized by heating is molded (pressed).
[4] The compound according to any one of [1] to [3],
   wherein a thickness of the insulating coating film is 10 nm or more and 200 nm or less.
[5] The compound according to any one of [1] to [4],
   wherein the insulating coating film further contains Fe₂O₃, and
   a maximum value of the content of Fe₂O₃ in the surface region is greater than 0% by atom and 10% by atom or less.
[6] The compound according to [5],
   wherein SiO₂ and Fe₂O₃ are mixed in the insulating coating film.
[7] The compound according to any one of [1] to [6],
   wherein the insulating coating film does not contain phosphorus.
[8] The compound according to any one of [1] to [7],
   wherein a total content of the first soft magnetic powder and the second soft magnetic powder in the whole of the compound is 94% by mass or more and 98% by mass or less.
[9] The compound according to any one of [1] to [8],
   wherein the resin composition contains an epoxy resin, a curing agent, and a coupling agent.
[10] The compound according to any one of [1] to [9],
   wherein a content of SiO₂ in the surface region is greater than the content of Fe₂O₃ in the surface region.
[11] The compound according to any one of [1] to [10],
   wherein the compound is used for a magnetic core of a coil.
[12] The compound according to any one of [1] to [10],
   wherein the compound is a sealing material also serving as an electromagnetic shielding material.
[13] A molded body (a compact) containing
   the compound according to any one of [1] to [12].
[14] A cured product of the compound according to any one of [1] to [12].

### Advantageous Effects of Invention

According to one aspect of the present invention, the compound excellent in the soft magnetic characteristics and the electrical insulating properties, the molded body containing the compound, and the cured product of the compound are provided.

### Brief Description of Drawings

[FIG. 1] FIG. 1 is a schematic cross-sectional view of a compound according to one embodiment of the present invention.
[FIG. 2] FIG. 2 illustrates a distribution of a content of Fe₂O₃ in a surface region of first soft magnetic particles used in Example 1 of the present invention.
[FIG. 3] FIG. 3 illustrates a distribution of a content of Fe₂O₃ in a surface region of first soft magnetic particles used in Example 2 of the present invention.
[FIG. 4] FIG. 4 illustrates a distribution of a content of Fe₂O₃ in a surface region of first soft magnetic particles used in Comparative Example 1.
[FIG. 5] FIG. 5 illustrates a distribution of a content of Fe₂O₃ in a surface region of first soft magnetic particles used in Comparative Example 2.
[FIG. 6] FIG. 6 illustrates a distribution of a content of Fe₂O₃ in a surface region of first soft magnetic particles used in Comparative Example 4.
[FIG. 7] FIG. 7 illustrates a distribution of a content of Fe₂O₃ in a surface region of first soft magnetic particles used in Comparative Example 5.

### Description of Embodiments

Hereinafter, a preferred embodiment of the present invention will be described with reference to the drawings. In the drawings, equivalent reference numerals are applied to equivalent constituents. The present invention is not limited to the following embodiment.

### (Compound, Molded Body, and Cured Product)

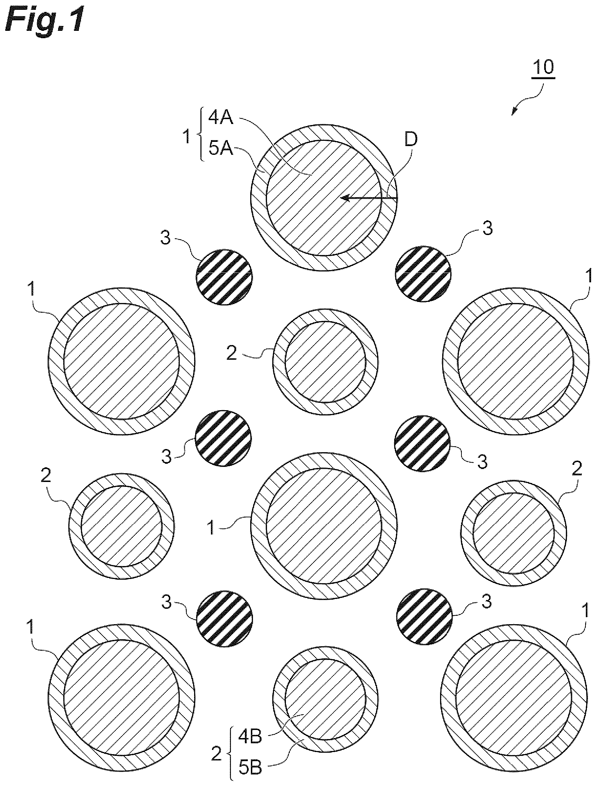

As illustrated in FIG. 1, a compound 10 according to this embodiment contains a first soft magnetic powder (first soft magnetic particles 1), a second soft magnetic powder (second soft magnetic particles 2), and a resin composition 3. The resin composition 3 contains a thermosetting resin. The first soft magnetic powder is composed of a plurality of first soft magnetic particles 1 (a large number of first soft magnetic particles 1). The second soft magnetic powder is composed of a plurality of second soft magnetic particles 2 (a large number of second soft magnetic particles 2). Each of the first soft magnetic powder and the second soft magnetic powder may also be referred to as a metal filler. In a molded body containing the compound 10 or a cured product of the compound 10, the resin composition 3 binds the metal fillers to each other. Further, the resin composition 3 interposed between the adjacent metal fillers electrically insulates the adjacent metal fillers. The compound may consist of only the first soft magnetic powder (the first soft magnetic particles 1), the second soft magnetic powder (the second soft magnetic particles 2), and the resin composition 3. The compound 10 may be a powder at an ordinary temperature (a room temperature).

A molded body according to this embodiment contains the compound 10 described above. The molded body according to this embodiment may consist of only the compound 10. The molded body may contain other members such as a coil, in addition to the compound 10. The molded body according to this embodiment may contain one or both of an uncured product of the resin composition 3 and a semi-cured product of the resin composition 3 (the resin composition 3 in a stage B). A cured product according to this embodiment is the cured product of the compound 10 described above, and contains a cured product of the resin composition 3 (the resin composition 3 in a stage C). Soft magnetic characteristics (for example, a high relative magnetic permeability) described below are characteristics common to the compound 10, the molded body, and the cured product. Electrical insulating properties (for example, a high volume resistivity and a high dielectric withstanding voltage) described below are also characteristics common to the compound 10, the molded body, and the cured product. A mechanical strength (for example, a high bending strength) described below is the characteristics of the cured product of the compound 10.

The particle diameter of the first soft magnetic powder is greater than the particle diameter of the second soft magnetic powder. For example, the average particle diameter of the first soft magnetic powder may be greater than the average particle diameter of the second soft magnetic powder. For example, D50 (the median diameter) of the first soft magnetic powder may be greater than D50 of the second soft magnetic powder. For example, D90 of the first soft magnetic powder may be greater than D90 of the second soft magnetic powder. In a case where the compound 10 contains only the first soft magnetic powder with a large particle diameter as the metal filler, gaps are likely to be formed between the plurality of adjacent first soft magnetic particles 1, and the filling rate of the metal filler in the compound 10 is less likely to increase. On the other hand, in a case where the compound 10 contains the first soft magnetic powder and the second soft magnetic powder as the metal filler, the second soft magnetic particles 2 smaller than the first soft magnetic particles 1 are filled in the gaps between the plurality of first soft magnetic particles 1, and the filling rate of the metal filler in the compound 10 increases. In other words, since the compound 10 contains the first soft magnetic powder and the second soft magnetic powder with different particle diameters, the specific weight of the compound 10 increases. As a result thereof, the soft magnetic characteristics are improved. Further, as the filling rate of the metal filler in the compound 10 increases, the cured product of the compound 10 becomes dense, and the mechanical strength of the cured product is improved.

For example, the average particle diameter of the first soft magnetic powder may be 11 µm or more and 45 µm or less. For example, the average particle diameter of the second soft magnetic powder may be 0.1 µm or more and 9.0 µm or less. In a case where the average particle diameter of the first soft magnetic powder is in the range described above, and the average particle diameter of the second soft magnetic powder is in the range described above, the filling rate of the metal filler in the compound 10 is likely to increase, and the soft magnetic characteristics and the mechanical strength are likely to be improved.

The average particle diameter, D50, and D90 of the first soft magnetic powder may be calculated from a particle size distribution based on the number, the volume, or the mass of the first soft magnetic particles 1. The average particle diameter, D50, and D90 of the second soft magnetic powder may be calculated from a particle size distribution based on the number, the volume, or the mass of the second soft magnetic particles 2. Each of the particle size distributions may be measured by a laser diffraction particle size distribution analyzer. Each of the particle size distributions may be calculated on the basis of the measurement of the mass or the volume of each of the soft magnetic particles by sieving. The shape of each of the first soft magnetic particles 1 and the second soft magnetic particles 2 is not particularly limited. For example, the shape of each of the first soft magnetic particles 1 and the second soft magnetic particles 2 may be a spherical shape, an approximately spherical shape, a flat shape, or an acicular shape.

The compound 10 according to this embodiment may be a compound (an all-in-one type compound) containing one type of soft magnetic powder as a raw material, the particle diameter of one part of the one type of soft magnetic powder may be in the range of the average particle diameter of the first soft magnetic powder, and the particle diameter of the other part of the one type of soft magnetic powder may be in the range of the average particle diameter of the second soft magnetic powder.

The number of peaks in the particle size distribution of the soft magnetic powder contained in the compound 10 may be one insofar as the compound 10 contains both of the first soft magnetic powder and the second soft magnetic powder. For example, the particle size distribution curve of the first soft magnetic powder and the particle size distribution curve of the second soft magnetic powder may overlap each other to form a particle size distribution curve in which the number of apparent peaks is one. In other words, one peak in the particle size distribution of the soft magnetic powder contained in the compound 10 may be separated into a peak corresponding to the particle diameter of the first soft magnetic powder and another peak corresponding to the particle diameter of the second soft magnetic powder.

The particle size distribution of the soft magnetic powder contained in the compound 10 may have at least two peaks. That is, the particle size distribution of the soft magnetic powder contained in the compound 10 may have a peak corresponding to the first soft magnetic powder and another peak corresponding to the second soft magnetic powder.

The compound 10 according to this embodiment may be a mixture of a compound containing only the first soft magnetic powder as the soft magnetic powder and a compound containing only the second soft magnetic powder as the soft magnetic powder.

As illustrated in FIG. 1, a part or all of the plurality of first soft magnetic particles 1 composing the first soft magnetic powder may include a metal portion 4A (core particle), and an insulating coating film 5A directly covering the metal portion 4A. Each of the first soft magnetic particles 1 may consist of only the metal portion 4A and the insulating coating film 5A. The insulating coating film 5A may directly cover a part or all of the metal portion 4A. A part or all of the insulating coating film 5A may be covered with the resin composition 3.

At least a part or all of the metal portion 4A may be a soft magnetic alloy. The soft magnetic alloy contains at least iron (Fe), chromium (Cr), and silicon (Si). The insulating coating film 5A contains at least silica (SiO₂). SiO₂ may be the main component of the insulating coating film 5A. A region of the first soft magnetic particle 1 where a depth D (a distance) from the outermost surface of the first soft magnetic particle 1 (the insulating coating film 5A) is 0 nm or more and 100 nm or less will be referred to as a surface region. A content (a concentration) of Fe₂O₃ in the surface region is 0% by atom or more and 10% by atom or less. The content (the concentration) of Fe₂O₃ in the surface region may be identical to a sum of contents (concentrations) of Fe and O composing Fe₂O₃ in the surface region. The content of Fe₂O₃ in the insulating coating film 5A may be approximately or completely identical to the content of Fe₂O₃ in the surface region, and the content of Fe₂O₃ in the insulating coating film 5A may be 0% by atom or more and 10% by atom or less. The content of Fe₂O₃ in the surface region may be measured by at least one analysis method of photoemission spectroscopy (XPS) and energy dispersive X-ray spectroscopy (EDX). The surface region may be a part or all of the insulating coating film 5A. That is, the thickness of the insulating coating film 5A may be greater than or equal to the thickness of the surface region. The insulating coating film 5A may be a part or all of the surface region. That is, the thickness of the insulating coating film 5A may be less than or equal to the thickness of the surface region. The content (the concentration) of Fe₂O₃ in the surface region may be 0.000% by atom or more and 0.045% by atom or less, or 0.045% by atom or more and 10.000% by atom or less.

The insulating coating film 5A of the first soft magnetic particles 1 may be formed by a wet method. In the wet method, a raw material powder and a treatment liquid are used. Each of a plurality of raw material particles composing the raw material powder is a soft magnetic alloy containing Fe, Cr, and Si. Each of the raw material particles may consist of only Fe, Cr, and Si. Each of the raw material particles may further contain other elements, in addition to Fe, Cr, and Si. The treatment liquid contains metal alkoxide as a solute (a reactive substrate), and contains an aqueous solution of alcohol as a solvent. For example, the metal alkoxide may be at least one alkoxysilane of tetraethoxysilane and tetramethoxysilane. In the wet method, the surface of the raw material particles reacts with the treatment liquid. As a result thereof, the surface of the raw material particles is changed to the insulating coating film 5A (or the surface region described above), and the inside of the raw material particles remains as the metal portion 4A. For example, SiO₂ (and Fe₂O₃) composing the insulating coating film 5A (or the surface region) may be generated by a reaction between Si (and Fe) composing the surface of the raw material particles and the solute in the treatment liquid. That is, at least a part of Si composing SiO₂ in the insulating coating film 5A (or the surface region) may be derived from Si composing the raw material particles, or Fe composing Fe₂O₃ in the insulating coating film 5A (or the surface region) may be derived from Fe composing the raw material particles. At least a part of Si composing SiO₂ in the insulating coating film 5A (or the surface region) may be derived from the alkoxysilane in the treatment liquid. Since Cr contained in the raw material particles suppresses the generation of Fe₂O₃ in the surface region, SiO₂ is more likely to be generated than Fe₂O₃ in the insulating coating film 5A and the surface region. For example, a portion of the metal portion 4A in contact with the insulating coating film 5A may contain Cr, or Cr contained in the portion of the metal portion 4A in contact with the insulating coating film 5A may suppress the generation of Fe₂O₃ in the insulating coating film 5A. As a result thereof, the surface region, where the content of Fe₂O₃ is 0% by atom or more and 10% by atom or less, is formed.

As shown in Comparative Example 3 described below, in a case where each of the raw material particles composing the raw material powder does not contain Cr, it is difficult to form the insulating coating film 5A by the wet method. That is, in a case where each of the raw material particles composing the raw material powder does not contain Cr, it is difficult to form the surface region where the content of Fe₂O₃ is 0% by atom or more and 10% by atom or less by the wet method.

As the content (Unit: % by mass) of the solute in the treatment liquid increases, the thickness of the insulating coating film 5A is likely to increase, and the content of SiO₂ in the insulating coating film 5A and the surface region is likely to increase. As a ratio of the mass of the treatment liquid to the mass of the raw material powder increases, the thickness of the insulating coating film 5A is likely to increase, and the content of SiO₂ in the insulating coating film 5A and the surface region is likely to increase. In the wet method, the raw material powder and the treatment liquid may be stirred. In the wet method, the raw material powder and the treatment liquid may be heated at an appropriate reaction temperature.

Since the particle diameter of the first soft magnetic powder is greater than the particle diameter of the second soft magnetic powder, the volume resistivity of the first soft magnetic powder is likely to affect the electrical insulating properties (for example, the dielectric withstanding voltage) of the entire compound 10. Since each of the first soft magnetic particles 1 composing the first soft magnetic powder includes the insulating coating film 5A covering the metal portion 4A, the first soft magnetic powder may have a high volume resistivity. Further, since both of the insulating coating film 5A and the resin composition 3 are interposed between the adjacent metal portions 4A in the compound 10, an insulation breakdown in the compound 10 is suppressed. Therefore, the compound 10, the molded body, and the cured product may have a high dielectric withstanding voltage.

In a case where the metal portion 4A contains Cr, the insulating coating film 5A contains SiO₂, and the content of Fe₂O₃ in the surface region is 0% by atom or more and 10% by atom or less, due to a large amount of SiO₂ in the insulating coating film 5A, the surface of each of the first soft magnetic particles 1 may have a large number of hydroxyl groups (silanol groups). In addition, due to the large amount of SiO₂ in the insulating coating film 5A, the equipotential of the surface of each of the first soft magnetic particles 1 is shifted to an acid side. According to such factors, the wettability and the reactivity of the first soft magnetic particles 1 and the resin composition 3 are improved, and the first soft magnetic particles 1 in the cured product of the compound 10 are strongly bonded to each other via the cured product of the resin composition 3. As a result thereof, the cured product of the compound 10 may have a high mechanical strength even under a high-temperature and humidity environment.

In a case where the metal portion 4A contains Cr, the insulating coating film 5A contains SiO₂, and the content of Fe₂O₃ in the surface region is 0% by atom or more and 10% by atom or less, not only the soft magnetic characteristics but also the electrical insulating properties are improved. Therefore, according to this embodiment, even in a case where the content of the metal filler in the compound is high, it is easy to make the soft magnetic characteristics and the electrical insulating properties compatible.

For example, the total content of the first soft magnetic powder and the second soft magnetic powder in the whole of the compound 10 may be 94% by mass or more and 98% by mass or less, or 95.5% by mass or more and 96.0% by mass or less. The content of the resin composition 3 in the whole of the compound 10 may be 2.0% by mass or more and 6.0% by mass or less, or 4.0% by mass or more and 4.5% by mass or less.

In the case of a compound of the related art that does not contain the first soft magnetic powder, the soft magnetic characteristics of the compound are improved as the content of the metal filler in the compound increases. However, as the content of the metal filler in the compound increases, the content of the resin composition 3 contributing to the electrical insulating properties and the mechanical strength decreases, and the electrical insulating properties and the mechanical strength are degraded. For example, in a case where the content of the metal filler in the compound of the related art that does not contain the first soft magnetic powder is 94% by mass or more, the compound has a high relative magnetic permeability, but it is difficult for the compound to have excellent electrical insulating properties, and it is difficult for the cured product of the compound to have a high mechanical strength. On the other hand, according to this embodiment, even in a case where the total content of the first soft magnetic powder and the second soft magnetic powder in the whole of the compound 10 is 94% by mass or more, due to the effect according to the insulating coating film 5A and the surface region described above, the compound is likely to have not only excellent soft magnetic characteristics but also excellent electrical insulating properties, and the cured product of the compound is likely to have a high mechanical strength.

As shown in Comparative Examples 1 and 3 described below, in a case where the metal portion 4A does not contain Cr, and the insulating coating film 5A is not provided, there is a tendency that the relative magnetic permeability, the dielectric withstanding voltage, and the mechanical strength are lower than those of this embodiment.

As shown in Comparative Examples 1 and 2 described below, in a case where the metal portion 4A does not contain Cr, and the maximum value of the content of Fe₂O₃ in the surface region is greater than 10% by atom, there is a tendency that the relative magnetic permeability and the mechanical strength are lower than those of this embodiment.

As shown in Comparative Example 4 described below, in a case where the metal portion 4A contains Cr, and the insulating coating film 5A is not provided, there is a tendency that the dielectric withstanding voltage and the mechanical strength are lower than those of this embodiment.

As shown in Comparative Example 5 described below, in a case where the metal portion 4A contains Cr, and the insulating coating film 5A substantially consists of a phosphate, there is a tendency that the dielectric withstanding voltage and the mechanical strength are lower than those of this embodiment.

An insulating coating film consisting of only at least one of SiO₂ and glass physically attached to the surface of the metal portion 4A (the metal particles) may be excluded from the insulating coating film 5A in the present invention. An insulating coating film formed by a method (for example, a dry method) other than the wet method may be excluded from the insulating coating film 5A in the present invention. For example, the dry method may be a method (mechano-fusion) for physically attaching an insulating substance containing at least one of SiO₂ and glass to the surface of the metal particles. Alternatively, the dry method may include physically mixing (physically blending) the insulating substance containing at least one of SiO₂ and glass and the metal particles. In a case where the insulating coating film 5A consists of only at least one of SiO₂ and glass physically attached to the surface of the metal portion 4A (the metal particles), at least one of the soft magnetic characteristics, the electrical insulating properties, and the mechanical strength is inferior to that of this embodiment.

The insulating coating film 5A does not have to contain phosphorus (P). The insulating coating film 5A does not have to contain a phosphate (phosphate glass) containing at least one of Fe, Si, and Cr. The phosphate is at least one of an inorganic phosphate and an organic phosphate. The insulating coating film 5A does not have to contain a phosphosilicate (phosphosilicate glass) containing at least one of Fe and Cr. Here, the insulating coating film 5A may contain a slight amount of phosphorus. The insulating coating film 5A may contain a slight amount of phosphate. The insulating coating film 5A may contain a slight amount of phosphosilicate.

As shown in Comparative Example 2 described below, in a case where the metal portion 4A does not contain Cr, and the insulating coating film 5A contains a phosphate, there is a tendency that the maximum value of the content of Fe₂O₃ in the surface region is greater than 10% by atom, and the relative magnetic permeability and the mechanical strength are lower than those of this embodiment.

As shown in Comparative Example 5 described below, in a case where the metal portion 4A contains Cr, and the insulating coating film 5A contains a phosphate, there is a tendency that the dielectric withstanding voltage and the mechanical strength are lower than those of this embodiment.

The insulating coating film 5A may further contain Fe₂O₃, in addition to SiO₂. SiO₂ and Fe₂O₃ may be mixed in the insulating coating film 5A. In a case where the insulating coating film 5A further contains Fe₂O₃, in addition to SiO₂, the maximum value of the content (the concentration) of Fe₂O₃ in the surface region may be greater than 0% by atom and 10% by atom or less, 0.84% by atom or more and 10% by atom or less, 1.29% by atom or more and 10% by atom or less, or 0.84% by atom or more and 1.30% by atom or less. The content of Fe₂O₃ in the insulating coating film 5A may be greater than 0% by atom and 10% by atom or less, 0.84% by atom or more and 10% by atom or less, 1.29% by atom or more and 10% by atom or less, or 0.84% by atom or more and 1.30% by atom or less.

The content of SiO₂ in the surface region may be greater than the content of Fe₂O₃ in the surface region. For example, the content (the concentration) of SiO₂ in the surface region may be 7.99% by atom or more and 50.00% by atom or less, 11.03% by atom or more and 50.00% by atom or less, 23% by atom or more and 50% by atom or less, 7.99% by atom or more and 32.00% by atom or less, 11.03% by atom or more and 32.00% by atom or less, 27% by atom or more and 32% by atom or less, or 7.99% by atom or more and 11.03% by atom or less. The content (the concentration) of SiO₂ in the surface region may be identical to the total content (concentration) of Si and O composing SiO₂ in the surface region. The content of SiO₂ in the surface region may be measured by at least one analysis method of XPS and EDX. The content of SiO₂ in the insulating coating film 5A may be approximately or completely identical to the content of SiO₂ in the surface region.

The insulating coating film 5A does not have to contain chromium. The insulating coating film 5A may contain chromium. For example, the insulating coating film 5A may contain an oxide of chromium (for example, Cr₂O₃), in addition to SiO₂. SiO₂ and an oxide of chromium (for example, Cr₂O₃) may be mixed in the insulating coating film 5A. The insulating coating film 5A may contain an oxide of chromium (for example, Cr₂O₃), in addition to SiO₂ and Fe₂O₃. SiO₂, Fe₂O₃, and an oxide of chromium (for example, Cr₂O₃) may be mixed in the insulating coating film 5A. The insulating coating film 5A may consist of only an oxide of silicon (for example, SiO₂). The insulating coating film 5A may consist of only SiO₂ and Fe₂O₃. The insulating coating film 5A may consist of SiO₂, Fe₂O₃, and an oxide of chromium (for example, Cr₂O₃). The insulating coating film 5A may contain a composite oxide (for example, a composite oxide containing silicon). The insulating coating film 5A may further contain other elements or compounds (for example, carbon or a carbon compound), in addition to Si, Fe, Cr, and O. The composition of the surface region may be approximately or completely identical to the composition of the insulating coating film 5A. Unless the insulating properties of the insulating coating film 5A are impaired, the insulating coating film 5A or the surface region may contain a slight amount of one or more types of metals (containing Si) common to the metal portion 4A.

The thickness of the insulating coating film 5A may be 10 nm or more and 200 nm or less, or 20 nm or more and 40 nm or less. In a case where the thickness of the insulating coating film 5A is 10 nm or more, the volume resistivity of the first soft magnetic powder sufficiently increases, and the electrical insulating properties are likely to be improved. Since not only the insulating coating film 5A but also the resin composition 3 have the electrical insulating properties, both of the insulating coating film 5A and the resin composition 3 contribute to the suppression of the insulation breakdown between the metal fillers. Therefore, even in a case where the insulating coating film 5A is thin, due to the contribution of the resin composition 3, the compound 10, the molded body, and the cured product may have sufficient electrical insulating properties. In a case where the thickness of the insulating coating film 5A is 200 nm or less, the soft magnetic characteristics are likely to be improved. Further, in a case where the thickness of the insulating coating film 5A is 200 nm or less, the compound 10 is likely to be kneaded, the heated compound 10 is likely to be fluid, the formation of voids (air gaps) in the cured product of the compound 10 is suppressed, and the mechanical strength is likely to be improved. The thickness of the insulating coating film 5A may be approximately or completely even. The thickness of the insulating coating film 5A may be measured on the cross-sectional surface of the first soft magnetic particles using a transmission electron microscope (TEM) and EDX.

The relative magnetic permeability of the cured product of the compound 10 may be 23 or more and 27 or less. The relative magnetic permeability of the cured product of the compound 10 may be 23 or more and 26 or less, or 23.9 or more and 25.7 or less.

The content of Fe in the metal portion 4A composing the first soft magnetic particles 1, for example, may be 70.0% by mass or more and 99.8% by mass or less. The content of Cr in the metal portion 4A, for example, may be 0.1% by mass or more and 15.0% by mass or less. The content of Si in the metal portion 4A, for example, may be 0.1% by mass or more and 15.0% by mass or less. The metal portion 4A may consist of only Fe, Cr, and Si. The metal portion 4A, as with the second soft magnetic particles 2 described below, may further contain other elements, in addition to Fe, Cr, and Si. The metal portion 4A may be crystalline or amorphous. The content of each element in the metal portion 4A may be measured by at least one analysis method of XPS and EDX.

The second soft magnetic particles 2 contain a soft magnetic material. For example, the second soft magnetic particles 2 may contain iron. The second soft magnetic particles 2 may contain at least one element selected from the group consisting of a base metal element, a noble metal element, a transition metal element, and a rare earth element, in addition to iron. For example, the metal element other than iron contained in the second soft magnetic particles 2 may be at least one element selected from the group consisting of copper (Cu), titanium (Ti), manganese (Mn), cobalt (Co), nickel (Ni), zinc (Zn), aluminum (Al), tin (Sn), chromium (Cr), barium (Ba), strontium (Sr), lead (Pb), and silver (Ag). The second soft magnetic particles 2 may contain a non-metal element, in addition to the metal element. For example, the non-metal element contained in the second soft magnetic particles 2 may be at least one element selected from the group consisting of oxygen (O), beryllium (Be), phosphorus (P), boron (B), and silicon (Si).

The second soft magnetic particles 2 may contain pure iron, or an alloy containing iron (an iron-based alloy). The second soft magnetic particles 2 may consist of only pure iron, or an alloy containing iron (an iron-based alloy). For example, the iron-based alloy contained in the second soft magnetic particles 2 may be a Fe-Cr-Si-based alloy, a Fe-Cr-based alloy, a Fe-Si-based alloy, a Fe-Si-Al-based alloy, a Fe-Ni-based alloy, a Fe-Cu-Ni-based alloy, a Fe-Co-based alloy, or a Fe-Ni-Cr-based alloy. The iron or the iron-based alloy contained in the second soft magnetic particles 2 may be crystalline or amorphous.

As illustrated in FIG. 1, a part or all of the plurality of second soft magnetic particles 2 composing the second soft magnetic powder may include a metal portion 4B (core particles), and an insulating coating film 5B directly covering the metal portion 4B. Each of the second soft magnetic particles 2 may consist of only the metal portion 4B and the insulating coating film 5B. The insulating coating film 5B may directly cover a part or all of the surface of the metal portion 4B. A part or all of the insulating coating film 5B may be covered with the resin composition 3. The insulating coating film 5B composing the second soft magnetic particles 2 improves the electrical insulating properties.

The metal portion 4B of the second soft magnetic particles 2 may contain pure iron or an iron-based alloy. The metal portion 4B of the second soft magnetic particles 2 may consist of only pure iron or an iron-based alloy. For example, the metal portion 4B of the second soft magnetic particles 2 may contain iron, chromium, and silicon. The metal portion 4B of the second soft magnetic particles 2 may consist of only iron, chromium, and silicon. The composition of the metal portion 4B of the second soft magnetic particles 2 may be approximately or completely the same as the composition of the metal portion 4A of the first soft magnetic particles 1. The metal portion 4B of the second soft magnetic particles 2 may be crystalline or amorphous.

The insulating coating film 5B of the second soft magnetic particles 2 may contain SiO₂. The insulating coating film 5B of the second soft magnetic particles 2 may consist of only SiO₂. The insulating coating film 5B of the second soft magnetic particles 2 may contain glass. The insulating coating film 5B of the second soft magnetic particles 2 may consist of only glass. For example, the glass contained in the insulating coating film 5B of the second soft magnetic particles 2 may contain at least one element selected from the group consisting of oxygen (O), boron (B), sodium (Na), and aluminum (Al), in addition to silicon (Si). The glass contained in the insulating coating film 5B of the second soft magnetic particles 2, for example, the glass contained in the insulating coating film 5B of the second soft magnetic particles 2 may be at least one of silicate glass (a silicate), phosphosilicate glass (a phosphosilicate), and borosilicate glass (a borosilicate).

The insulating coating film 5B of the second soft magnetic particles 2 may contain at least SiO₂, and the content (the concentration) of Fe₂O₃ in a surface region of the second soft magnetic particles 2 where a depth (a distance) from the outermost surface of the second soft magnetic particles 2 (the insulating coating film 5B) is 0 nm or more and 100 nm or less may be 0% by atom or more and 10% by atom or less. The composition of the insulating coating film 5B of the second soft magnetic particles 2 may be approximately or completely the same as the composition of the insulating coating film 5A of the first soft magnetic particles 1, and the insulating coating film 5B of the second soft magnetic particles 2 may have the same function as that of the insulating coating film 5A of the first soft magnetic particles 1 described above.

As with the insulating coating film 5A of the first soft magnetic particles 1, the insulating coating film 5B of the second soft magnetic particles 2 may be formed by the wet method described above. In the wet method, instead of the treatment liquid described above, a treatment liquid containing an inorganic phosphoric acid or an organic phosphoric acid may be used. The insulating coating film 5B of the second soft magnetic particles 2 may be formed by the dry method described above.

The thickness of the insulating coating film 5B of the second soft magnetic particles 2 may be 5 nm or more and 40 nm or less. In a case where the insulating coating film 5B is 5 nm or more, the volume resistivity of the second soft magnetic powder sufficiently increases, and the electrical insulating properties are likely to be improved. Since not only the insulating coating film 5B but also the resin composition 3 have the electrical insulating properties, both of the insulating coating film 5B and the resin composition 3 contribute to the suppression of the insulation breakdown between the metal fillers. Therefore, even in a case where the insulating coating film 5B is thin, due to the contribution of the resin composition 3, the compound 10, the molded body, and the cured product may have sufficient electrical insulating properties. In a case where the insulating coating film 5B is 40 nm or less, the soft magnetic characteristics are likely to be improved. The thickness of the insulating coating film 5B of the second soft magnetic particles 2 may be approximately or completely even.

The composition of the second soft magnetic particles 2 (the metal portion 4B, and the insulating coating film 5B and the surface region), and the thickness of the insulating coating film 5B of the second soft magnetic particles 2 may be measured by the same method as that of the first soft magnetic particles 1.

The mass of the first soft magnetic powder may be represented by M1, and the mass of the second soft magnetic powder may be represented by M2. M1/(M1 + M2) may be 0.70 or more and 0.95 or less, and M2/(M1 + M2) may be 0.05 or more and 0.30 or less. In a case where each of M1/(M1 + M2) and M2/(M1 + M2) is in the range described above, the second soft magnetic particles 2 smaller than the first soft magnetic particles 1 are likely to be filled in the gaps between the plurality of first soft magnetic particles 1, and the filling rate of the metal filler in the compound 10 (the specific weight of the compound 10) is likely to increase. As a result thereof, the soft magnetic characteristics and the mechanical strength are likely to be improved.

The compound 10 may further contain a non-metal filler, in addition to the first soft magnetic powder and the second soft magnetic powder. For example, the compound 10 may contain a filler consisting of silica (SiO₂) (a particulate filling material), as the non-metal filler. The particle diameter of the non-metal filler may be approximately or completely identical to the particle diameter of the first soft magnetic powder or the second soft magnetic powder.

The compound 10 may be fluidized by heating at a temperature lower than the thermal curing temperature of the resin composition 3, and the fluidized compound 10 may be molded. For example, the compound 10 is likely to be used for transfer molding. The transfer molding is a type of injection molding method. The transfer molding may also be referred to as pressure molding. The transfer molding may include a step of heating and fluidizing the powdered compound 10 in a heating chamber, and a step of feeding (injecting) the fluidized compound 10 into a metallic mold from the heating chamber through a casting runner.

The lowest melt viscosity of the compound 10 at 175°C may be 10 Pa·s or more and 250 Pa·s or less, or 52 Pa·s or more and 185 Pa·s or less. The spiral flow of the compound 10 at 175°C may be 30 cm or more and 200 cm or less, or 65 cm or more and 71 cm or less. Since the heated compound 10 has excellent fluidity in a case where each of the lowest melt viscosity and the spiral flow is in the range described above, the compound 10 is likely to flow through the narrow casting runner without a pause (without entrapping air bubbles), and is likely to be evenly filled in a space (a cavity) in the metallic mold. As a result thereof, it is possible to produce the molded body and the cured product thereof with few defects such as an air gap or burr by the transfer molding of the compound 10.

The molding method of the compound 10 is not limited to the transfer molding. For example, the molding method of the compound 10 may be extrusion molding or compression molding (powder compacting molding).

The compound 10 may have both of the electrical insulating properties required for a sealing material for an electronic device and the soft magnetic characteristics (electromagnetic shielding capability) required for an electromagnetic shielding material. Therefore, the compound 10, and the molded body and the cured product thereof may be a sealing material also serving as an electromagnetic shielding material. For example, the sealing material also serving as the electromagnetic shielding material may be a sealing material (such as underfill) for a semiconductor package such as an IC package and an LSI package.

The compound 10 and the molded body thereof may be used as a raw material for a magnetic core of a coil. That is, the cured product of the compound 10 may be the magnetic core of the coil. For example, a specific industrial product (a product containing a coil) produced by using the compound 10 may be an inductor, a transformer, a reactor, a thyristor valve, a noise filter (an EMI filter), a choke coil, a rotor and a yoke of a motor, a solenoid core (a fixed iron core) for an electromagnetic valve built in an electronically controlled fuel injector of an internal-combustion engine, and the like.

### (Specific Examples of Resin Composition)

The resin composition is the remaining portion (a non-volatile component) excluding the filler (the first soft magnetic powder, the second soft magnetic powder, and the like) and an organic solvent in the compound. The resin composition contains at least a thermosetting resin. The resin composition may further contain at least one component selected from the group consisting of a curing agent, a curing accelerator (a curing catalyst), a coupling agent, a wax (a mold release agent), and a flame retardant, in addition to the thermosetting resin. Specific examples of each component are as follows.

The thermosetting resin contained in the resin composition may be at least one resin selected from the group consisting of an epoxy resin, a phenolic resin, a bismaleimide resin, a polyimide resin, and a polyamide imide resin. The resin composition may further contain other resins (for example, a thermosplastic resin), in addition to the thermosetting resin. For example, the resin composition may further contain at least one other resin selected from the group consisting of a polyphenylene sulfide resin, an acrylic resin, polyethylene, polypropylene, polystyrene, polyvinyl chloride, polyethylene terephthalate, and a silicone resin.

### <Epoxy Resin and Curing Agent>

The epoxy resin may be at least one selected from the group consisting of a biphenyl-type epoxy resin, a stilbene-type epoxy resin, a diphenyl methane-type epoxy resin, a sulfur atom-containing epoxy resin, a novolac-type epoxy resin, a dicyclopentadiene-type epoxy resin, a salicylic aldehyde-type epoxy resin, a copolymerized epoxy resin of naphthols and phenols, an epoxidized aralkyl-type phenolic resin, a bisphenol-type epoxy resin, a glycidyl ether-type epoxy resin of alcohols, a glycidyl ether-type epoxy resin of a para-xylene-modified phenolic resin and/or a meta-xylene-modified phenolic resin, a glycidyl ether-type epoxy resin of terpene-modified phenolic resin, a cyclopentadiene-type epoxy resin, a glycidyl ether-type epoxy resin of a polycyclic aromatic ring-modified phenolic resin, a glycidyl ether-type epoxy resin of a naphthalene ring-containing phenolic resin, a glycidyl ester-type epoxy resin, a glycidyl-type or methyl glycidyl-type epoxy resin, an alicyclic epoxy resin, a halogenated phenol novolac-type epoxy resin, an ortho-cresol novolac-type epoxy resin, a hydroquinone-type epoxy resin, a trimethylol propane-type epoxy resin, and a linear aliphatic epoxy resin obtained by oxidizing an olefin bond with an peroxy acid such as a peracetic acid.

At least a part of the epoxy resin may be naphthalene-type epoxy resin having a naphthalene structure. The naphthalene-type epoxy resin is a solid at an ordinary temperature. In a case where the compound contains the naphthalene-type epoxy resin, a product (the cured product of the compound) produced from the compound is likely to have a high mechanical strength at a room temperature and a high temperature. The naphthalene-type epoxy resin may be at least one epoxy resin selected from the group consisting of a naphthalene diepoxy compound, a naphthylene ether-type epoxy resin, a naphthalene novolac-type epoxy resin, a methylene-bonded dimer of a naphthalene diepoxy compound, a methylene-bonded body of a naphthalene monoepoxy compound and a naphthalene diepoxy compound, and the like. The epoxy resin may include a difunctional epoxy resin. For example, the difunctional epoxy resin may be at least one of an α-naphthol-type epoxy resin and a β-naphthol-type epoxy resin.

The epoxy resin may include at least one of a trifunctional epoxy resin and a tetrafunctional epoxy resin. The naphthalene-type epoxy resin described above may be at least one of a trifunctional epoxy resin and a tetrafunctional epoxy resin. The trifunctional epoxy resin is an epoxy resin composed of a structural unit having three epoxy groups. The tetrafunctional epoxy resin is an epoxy resin composed of a structural unit having four epoxy groups. In a case where the epoxy resin includes at least one of the trifunctional epoxy resin and the tetrafunctional epoxy resin, in the process of the thermal curing of the compound, the epoxy resins are three-dimensionally cross-linked to each other to form a strong cross-linked network. As a result thereof, the movement of the epoxy resin in the cured product of the compound is likely to be suppressed under a high temperature. That is, the glass transition temperature of each of the trifunctional epoxy resin and the tetrafunctional epoxy resin is higher than the glass transition temperature of the difunctional epoxy resin. Therefore, in a case where the epoxy resin includes at least one of the trifunctional epoxy resin and the tetrafunctional epoxy resin, the cured product of the compound (the product produced from the compound) is likely to have a high mechanical strength at a high temperature.

The compound may contain one type of epoxy resin among the epoxy resins described above. The compound may contain a plurality of types of epoxy resins among the epoxy resins described above.

The curing agent is classified into a curing agent for curing the epoxy resin in a range from a low temperature to a room temperature and a thermal curable curing agent for curing the epoxy resin in association with heating. For example, the curing agent for curing the epoxy resin in the range from the low temperature to the room temperature is aliphatic polyamine, polyaminoamide, polymercaptan, and the like. For example, the thermal curable curing agent is aromatic polyamine, an acid anhydride, a phenol novolac resin, dicyan diamide (DICY), and the like.

In the case of using the curing agent for curing the epoxy resin in the range from the low temperature to the room temperature, there is a tendency that the glass transition point of the cured product of the epoxy resin is low, and the cured product of the epoxy resin is soft. As a result thereof, the cured product of the compound is also likely to be soft. Therefore, from the viewpoint of improving the heat resistance (the mechanical strength at a high temperature) of the cured product of the compound, the curing agent may be preferably the thermal curable curing agent, more preferably the phenolic resin, and even more preferably the phenol novolac resin. In particular, by using the phenol novolac resin as the curing agent, the cured product of the epoxy resin with a high glass transition point is likely to be obtained. As a result thereof, the heat resistance of the cured product of the compound is likely to be improved.

A part or all of the curing agent may be a phenolic resin. For example, the phenolic resin may be at least one selected from the group consisting of an aralkyl-type phenolic resin, a dicyclopentadiene-type phenolic resin, a salicylic aldehyde-type phenolic resin, a novolac-type phenolic resin, a copolymerized phenolic resin of benzaldehyde-type phenol and aralkyl-type phenol, a para-xylene and/or meta-xylene-modified phenolic resin, a melamine-modified phenolic resin, a terpene-modified phenolic resin, a dicyclopentadiene-type naphthol resin, a cyclopentadiene-modified phenolic resin, a polycyclic aromatic ring-modified phenolic resin, a biphenyl-type phenolic resin, and a triphenyl methane-type phenolic resin. The phenolic resin may be a copolymer composed of two or more types of phenolic resins among the phenolic resins described above.

The phenol novolac resin may be a resin obtained by condensing or co-condensing phenols and/or naphthols and aldehydes under an acid catalyst. The phenols composing the phenol novolac resin may be at least one selected from the group consisting of phenol, cresol, xylenol, resorcin, catechol, bisphenol A, bisphenol F, phenyl phenol, and aminophenol. The naphthols composing the phenol novolac resin may be at least one selected from the group consisting of α-naphthol, β-naphthol, and dihydroxynaphthalene. The aldehydes composing the phenol novolac resin may be at least one selected from the group consisting of formaldehyde, acetaldehyde, propionaldehyde, benzaldehyde, and salicylic aldehyde.

The curing agent may be a compound having two phenolic hydroxyl groups in one molecule. For example, the compound having two phenolic hydroxyl groups in one molecule may be at least one selected from the group consisting of resorcin, catechol, bisphenol A, bisphenol F, and substituted or non-substituted biphenol.

The compound may contain, as the curing agent, one type of phenolic resin among the phenolic resins described above. The compound may contain, as the curing agent, a plurality of types of phenolic resins among the phenolic resins described above.

A ratio of a hydroxyl equivalent of the phenolic resin to an epoxy equivalent of the epoxy resin may be 0.5 or more and 1.5 or less. That is, a ratio of an active group (a phenolic OH group) in the phenolic resin that reacts with the epoxy group in the epoxy resin may be 0.5 equivalents or more and 1.5 equivalents or less with respect to 1 equivalent of the epoxy group in the epoxy resin. In a case where the ratio of the active group in the phenolic resin is less than 0.5 equivalents, the amount of OH groups per unit mass of the epoxy resin after curing decreases, and the curing rate of the resin composition (the epoxy resin) decreases. In addition, in a case where the ratio of the active group in the phenolic resin is less than 0.5 equivalents, the glass transition temperature of the obtained cured product is likely to decrease, and a sufficient elastic modulus of the cured product is less likely to be obtained. On the other hand, in a case where the ratio of the active group in the phenolic resin is 1.5 equivalents or less, the cured product of the compound is likely to have a high mechanical strength.

### <Curing Accelerator>

The curing accelerator (the curing catalyst) is not limited insofar as the curing accelerator is a composition reacting with the epoxy resin to accelerate the curing of the epoxy resin. For example, the curing accelerator may be a urea compound. The curing accelerator may be imidazoles such as alkyl group-substituted imidazole or benzoimidazole. The curing accelerator may be a phosphorus-based curing accelerator. The phosphorus-based curing accelerator may be at least one curing accelerator selected from the group consisting of triphenyl phosphine-benzoquinone, tris-4-hydroxyphenyl phosphine-benzoquinone, tetraphenyl phosphonium/tetrakis(4-methyl phenyl) borate, tetra(n-butyl) phosphonium tetraphenyl borate, and the like. The cured product of the compound containing the curing accelerator described above is likely to have a high mechanical strength at a high temperature. In addition, the compound containing the curing accelerator described above is likely to be stably stored for a long period of time even under a high temperature and humidity environment. The compound may contain one type of curing accelerator. The compound may contain a plurality of types of curing accelerators.

The blending amount of the curing accelerator is not particularly limited. From the viewpoint of improving the curing properties and the fluidity of the epoxy resin during moisture-absorption, the blending amount of the curing accelerator may be 0.1 parts by mass or more and 30 parts by mass or less with respect to 100 parts by mass of the epoxy resin. In a case where the blending amount of the curing accelerator is 0.1 parts by mass or more, a sufficient curing accelerating effect is likely to be obtained. In a case where the blending amount of the curing accelerator is 30 parts by mass or less, the compound is likely to be stably stored. From the same reason, the content of the curing accelerator may be 0.001 parts by mass or more and 5 parts by mass or less with respect to the total mass of the epoxy resin and the curing agent (for example, a phenolic resin).

### <Coupling Agent>

The coupling agent may be a coupling agent that reacts with a glycidyl group of the resin composition such as an epoxy resin. The coupling agent improves adhesiveness between the first soft magnetic particles and the second soft magnetic particles and the resin composition, and improves the mechanical strength of the cured product of the compound. The coupling agent that reacts with the glycidyl group may be a silane-based compound (a silane coupling agent). The silane coupling agent, for example, may be at least one selected from the group consisting of epoxy silane, mercaptosilane, aminosilane, alkyl silane, ureidosilane, acid anhydride-based silane, and vinyl silane. A more specific silane coupling agent may be at least one selected from the group consisting of vinyl trimethoxysilane, vinyl triethoxysilane, 2-(3,4-epoxy cyclohexyl) ethyl trimethoxysilane, 3-glycidoxypropyl methyl dimethoxysilane, 3-glycidoxypropyl trimethoxysilane, 3-glycidoxypropyl methyl diethoxysilane, 3-glycidoxypropyl methyl diethoxysilane, 3-glycidoxypropyl triethoxysilane, p-styryl trimethoxysilane, 3-methacryloxypropyl methyl dimethoxysilane, 3-methacryloxypropyl trimethoxysilane, 3-methacryloxypropyl methyl diethoxysilane, 3-methacryloxypropyl triethoxysilane, 3-acryloxypropyl trimethoxysilane, N-2-(aminoethyl)-3-aminopropyl methyl dimethoxysilane, N-2-(aminoethyl)-3-aminopropyl trimethoxysilane, N-2-(aminoethyl)-3-aminopropyl triethoxysilane, 3-aminopropyl trimethoxysilane, 3-aminopropyl triethoxysilane, 3-triethoxysilyl-N-(1,3-dimethyl-butylidene) propyl amine, N-phenyl-3-aminopropyl trimethoxysilane, a hydrochloride of N-(vinyl benzyl)-2-aminoethyl-3-aminopropyl trimethoxysilane, 3-ureidopropyl triethoxysilane, 3-mercaptopropyl methyl dimethoxysilane, 3-mercaptopropyl trimethoxysilane, bis(triethoxysilyl propyl) tetrasulfide, 3-isocyanate propyl triethoxysilane, a polycondensate of dimethyl silane, a polycondensate of diphenyl silane, and a copolycondensate of dimethyl silane and diphenyl silane.

A part or all of the coupling agent may have a succinic anhydride group. By the coupling agent having a succinic anhydride group, the adhesiveness between the first soft magnetic particles and the second soft magnetic particles and the resin composition such as an epoxy resin is likely to be improved, the coupling agent is likely to be cross-linked with the resin composition such as an epoxy resin under a high humidity environment, and the heat resistance and the weather resistance of the product produced from the compound (the cured product of the compound) are likely to be improved. The compound may contain one type of coupling agent among the coupling agents described above. The compound may contain a plurality of types of coupling agents among the coupling agents described above.

### <Wax>

The compound may contain a wax. The wax may also be referred to as a lubricant or a mold release agent. By the compound containing the wax, the fluidity and the moldability of the compound are improved, and the mold releasability of the compound is improved. As a result thereof, the accuracy of the shape and the dimension of the product produced from the compound (the cured product of the compound) is improved, and a structural defect of the product is likely to be suppressed. For example, the wax may be at least one of a saturated fatty acid, a saturated fatty acid salt, and saturated fatty acid ester. The wax may be a synthetic wax. For example, the wax may be at least one selected from the group consisting of a caproic acid, an enanthic acid, a caprylic acid, a pelargonic acid, a capric acid, a lauric acid, a myristic acid, a pentadecanoic acid, a palmitic acid, a margaric acid, a stearic acid, an arachidic acid, a heneicosylic acid, a behenic acid, a lignoceric acid, a cerotic acid, a montanic acid, a melissic acid, calcium caproate, barium caproate, calcium enanthate, barium enanthate, calcium caprylate, barium caprylate, calcium pelargonate, barium pelargonate, calcium caprate, barium caprate, calcium laurate, barium laurate, calcium myristate, calcium pentadecanoate, calcium palmitate, calcium margarate, calcium stearate, calcium arachidate, calcium heneicosylate, calcium behenate, calcium lignocerate, calcium cerotate, calcium montanate, calcium melissate, barium laurate, barium myristate, barium pentadecanoate, barium palmitate, barium margarate, barium stearate, barium arachidate, barium heneicosylate, barium behenate, barium lignocerate, barium cerotate, barium montanate, barium melissate, lauric acid ester, myristic acid ester, pentadecanoic acid ester, palmitic acid ester, margaric acid ester, stearic acid ester, arachidic acid ester, heneicosylic acid ester, behenic acid ester, lignoceric acid ester, cerotic acid ester, montanic acid ester, and melissic acid ester. The compound may contain a wax other than the waxes described above. For example, the wax may be at least one selected from the group consisting of a magnesium salt of the saturated fatty acid, an aluminum salt of the saturated fatty acid, a 12-oxystearic acid, calcium ricinoleate, stearic acid amide, oleic acid amide, erucic acid amide, behenic acid amide, palmitic acid amide, lauric acid amide, hydroxystearic acid amide, methylene bisstearic acid amide, ethylene bisstearic acid amide, ethylene bislauric acid amide, distearyl adipic acid amide, ethylene bisoleic acid amide, dioleyl adipic acid amide, N-stearyl stearic acid amide, N-oleyl stearic acid amide, N-stearyl erucic acid amide, methylol stearic acid amide, methylol behenic acid amide, ethylene glycol, stearyl alcohol, polyethylene glycol, polypropylene glycol, polytetramethylene glycol, silicone oil, silicone grease, fluorine-based oil, fluorine-based grease, a fluorine-containing resin powder, a paraffin wax, a polyethylene wax, an oxidized polyethylene wax, an amide wax, a polypropylene wax, an ester wax, a carnauba wax, a microwax, and the like. The compound may contain one type of wax among the waxes described above. The compound may contain a plurality of types of waxes among the waxes described above.

### <Flame Retardant>

For the environmental safety, the recyclability, the mold workability, and the low cost of the compound, the compound may contain a flame retardant. The flame retardant, for example, may be at least one selected from the group consisting of a bromine-based flame retardant, a phosphorus-based flame retardant, a hydrated metal compound-based flame retardant, a silicone-based flame retardant, a nitrogen-containing compound, a hindered amine compound, an organic metal compound, and an aromatic engineering plastic. The compound may contain one type of flame retardant among the flame retardants described above, or may contain a plurality of types of flame retardants among the flame retardants described above.

### (Method for Producing Compound)

The compound is obtained by kneading the metal filler (the first soft magnetic powder and the second soft magnetic powder), each component composing the resin composition while heating. For example, a kneading means may be a kneader, a roll, or a stirrer. The resin composition may cover a part or all of the surface of each of the soft magnetic particles composing the metal filler by heating and mixing the metal filler and the resin composition. A part or all of the resin composition may be a semi-cured product by heating and mixing the metal filler and the resin composition.

The metal filler (the first soft magnetic powder and the second soft magnetic powder), and all the components composing the resin composition may be collectively kneaded. A mixture of the metal filler and the coupling agent may be prepared in advance, and the mixture may be kneaded with the other components of the resin composition. A mixture of each component of the resin composition excluding the curing accelerator and the metal filler may be prepared in advance, and the mixture may be kneaded with the curing accelerator. A mixture of each component of the resin composition excluding the wax and the metal filler may be prepared in advance, and the mixture may be kneaded with the wax.

A kneading time depends on the kneading means, the volume of the kneading means, and the production amount of the compound. The kneading time is not limited. For example, the kneading time may be 1 minute or longer, 2 minutes or longer, or 3 minutes or longer. The kneading time may be 20 minutes or shorter, 15 minutes or shorter, or 10 minutes or shorter. In a case where the kneading time is shorter than 1 minute, the kneading is insufficient, the moldability of the compound is impaired, and the curing degree of the compound varies. For example, in a case where the kneading time is longer than 20 minutes, the thermal curing of the resin composition excessively progresses, and the fluidity and the moldability of the resin composition are likely to be impaired. The temperature (the heating temperature) of the metal filler and the resin composition during kneading may be a temperature at which the semi-cured product of the thermosetting resin (the resin composition in the stage B) is generated, and the generation of the cured product of the thermosetting resin (the resin composition in the stage C) is suppressed. The heating temperature may be a temperature lower than the activation temperature of the curing accelerator. For example, the heating temperature may be 50°C or higher, 60°C or higher, or 70°C or higher. The heating temperature may be 150°C or lower, 120°C or lower, or 110°C or lower. In a case where the heating temperature is in the range described above, the resin composition during kneading is softened and likely to cover the surface of each of the soft magnetic particles, the semi-cured product of the thermosetting resin is likely to be generated, and the complete curing of the thermosetting resin is likely to be suppressed.

### (Method for Producing Molded Body and Cured Product)

The molded body is obtained by molding the compound described above. According to the thermal treatment of the molded body (the thermal curing of the resin composition in the molded body), the metal fillers are strongly bound to each other by the cured product of the resin composition, and the cured product of the compound is obtained. For example, the molding method of the compound may be transfer molding, extrusion molding, or compression molding (powder compacting molding). The dimension and the shape of the metallic mold used to mold the compound may be selected in accordance with the industrial product produced by using the compound. The thermal treatment temperature of the molded body may be a temperature at which the resin composition in the molded body is sufficiently cured, or may be higher than or equal to the activation temperature of the curing accelerator. For example, the thermal treatment temperature may be 100°C or higher and 300°C or lower, or 150°C or higher and 250°C or lower. In a case where the thermal treatment temperature is higher than 300°C, the metal filler is oxidized by a slight amount of oxygen inevitably contained in the atmosphere of the thermal treatment, or the resin cured product is degraded. In order to suppress the oxidization of the metal filler in the molded body, the thermal treatment of the molded body may be performed under an inert atmosphere. In order to sufficiently cure the resin composition while suppressing the oxidization of the metal filler and the degradation of the resin cured product, the thermal treatment time may be several minutes or longer and 10 hours or shorter, or 5 minutes or longer and 8 hours or shorter.

The present invention is not necessarily limited to the embodiment described above. Various modifications of the present invention are available within a range not departing from the spirit of the present invention, and modification examples thereof are also included in the present invention.

### Examples

The present invention will be described in detail by Examples and Comparative Examples described below. The present invention is not limited by Examples described below.

### (Example 1)

### <Preparation of First Soft Magnetic Powder>

A first soft magnetic powder was prepared by the wet method described above. As the raw material powder of the first soft magnetic powder, "6B2", manufactured by EPSON ATMIX Corporation, was used. "6B2" is a powder of a soft magnetic alloy consisting of Fe, Cr, and Si. The average particle diameter of "6B2" was 24 µm. The average particle diameter of a second soft magnetic powder was approximately identical to the average particle diameter of the raw material powder (6B2). The particle diameter of the first soft magnetic powder was even. A plurality of first soft magnetic particles composing the first soft magnetic powder were analyzed by the following XPS method.

The plurality of first soft magnetic particles were arranged on the surface of a flat base material without a gap and adhered to the surface of the base material. In order to measure the average thickness of an insulating coating film, and the average composition of each of the insulating coating film and a surface region, the particle diameter of the plurality of first soft magnetic particles adhering to the surface of the base material was even. From the same reason, the plurality of first soft magnetic particles were disposed on the surface of the base material such that the plurality of first soft magnetic particles do not overlap each other in a direction perpendicular to the surface of the base material. The ion etching of the surface of each of the plurality of first soft magnetic particles adhering to the surface of the base material, and the detection of photoelectrons discharged from the cross-sectional surface of each of the first soft magnetic particles exposed by the ion etching were repeated. By repeating the ion etching and the detection of the photoelectrons, the average composition of the surface region of the first soft magnetic particles where a depth D from the outermost surface of the first soft magnetic particles was 0 nm or more and 100 nm or less was analyzed. An X-ray simultaneously applied to the plurality of first soft magnetic particles during the measurement described above was a Kα-ray of Al. The diameter of the spot of the X-ray was 200 µm. In the measurement described above, an X-ray photoemission spectroscope (K-Alpha), manufactured by Thermo Fisher Scientific Inc., was used.

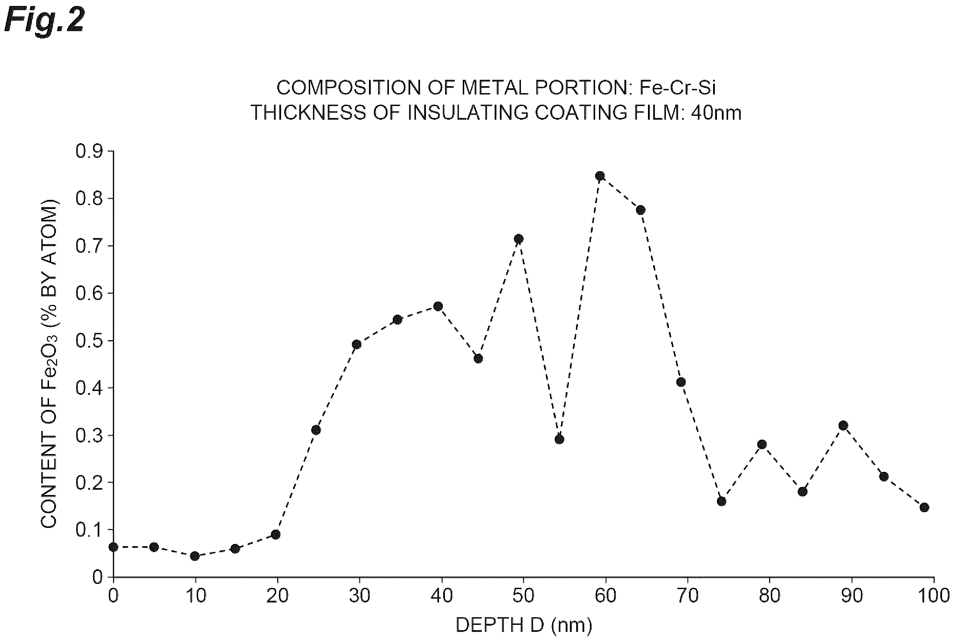

FIG. 2 illustrates the distribution of the content of Fe₂O₃ in the surface region of the first soft magnetic particles of Example 1. The distribution illustrated in FIG. 2 is a distribution measured by the XPS method described above. The minimum value of the content of Fe₂O₃ in the surface region of Example 1 was approximately 0.045% by atom. The maximum value of the content of Fe₂O₃ in the surface region of Example 1 was approximately 0.848% by atom. The content (the minimum value) of SiO₂ in the surface region of Example 1 was 11.03% by atom.

By TEM and EDX, the cross-sectional surface of the first soft magnetic particles was analyzed. The result of the analysis by TEM and EDX was approximately coincident with the result of the analysis by XPS. The results of the analysis indicated that the first soft magnetic particles have the following characteristics.

The first soft magnetic particles consisted of a metal portion, and an insulating coating film directly covering the entire metal portion.

The metal portion contained a soft magnetic alloy consisting of iron, chromium, and silicon.

The main component (a component other than the detected Fe₂O₃) of the insulating coating film was SiO₂. SiO₂ that is the main component, and a slight amount of Fe₂O₃ were mixed in the insulating coating film.

The average value of the thickness of the insulating coating film was 40 nm.

### <Preparation of Second Soft Magnetic Powder>

A second soft magnetic powder was prepared by the wet method described above. As the raw material powder of the second soft magnetic powder, "SAP-2C", manufactured by SINTOKOGIO, LTD., was used. "SAP-2C" is a powder of a soft magnetic alloy consisting of Fe, Cr, and Si. The average particle diameter of "SAP-2C" was 2 µm. The average particle diameter of the second soft magnetic powder was approximately identical to the average particle diameter of the raw material powder (SAP-2C). The particle diameter of the second soft magnetic powder was even. The average particle diameter of the second soft magnetic powder was less than the average particle diameter of the first soft magnetic powder. A plurality of second soft magnetic particles composing the second soft magnetic powder were analyzed by the method described above, as with the first soft magnetic particles. The result of the analysis indicated that the second soft magnetic particles have the following characteristics.

The second soft magnetic particles consisted of a metal portion, and an insulating coating film directly covering the entire metal portion.

The metal portion contained a soft magnetic alloy consisting of iron, chromium, and silicon.

The main component of the insulating coating film was SiO₂.

The average value of the thickness of the insulating coating film was 5 nm.

### <Preparation of Compound>

As a component composing a resin composition, an epoxy resin, a curing agent, a curing accelerator (a catalyst), a coupling agent, and a wax (a mold release agent) were used.

As the epoxy resin, "NC-3000", manufactured by Nippon Kayaku Co., Ltd., and "TECHMORE VG-3101L", manufactured by Printec Corporation, were used.

"NC-3000" is a biphenyl aralkyl-type epoxy resin. The mass of "NC-3000" was 60 g.

"TECHMORE VG3101L" is a trifunctional epoxy resin, and is a derivative of 1-[α-methyl-α-(4-hydroxyphenyl) ethyl]-4-[α,α-bis(4-hydroxyphenyl) ethyl] benzene. The mass of "TECHMORE VG3101L" was 40 g.

As the curing agent, "HF-3M", manufactured by UBE Corporation (formerly Meiwa Plastic Industries, Ltd), was used. "HF-3M" is a phenolic resin. The mass of "HF-3M" was 43.2 g.

As the curing accelerator (the catalyst), "U-CAT3512T", manufactured by San-Apro Ltd., was used. "U-CAT3512T" is aromatic dimethyl urea.

As the coupling agent, "KBM-803" and "KBM-5803", manufactured by Shin-Etsu Chemical Co., Ltd., were used.

"KBM-803" is 3-mercaptopropyl trimethoxysilane. The mass of "KBM-803" was 1.9 g.

"KBM-5803" is 8-methacryloxyoctyl trimethoxysilane. The mass of "KBM-5803" was 1.9 g.

As the wax (the mold release agent), "Licowax OP", manufactured by Clariant Chemicals Co., Ltd., was used. "Licowax OP" is montanic acid ester partially gelled by calcium hydroxide. The mass of "Licowax OP" was 2.0 g.

A compound (a powder) of Example 1 was obtained by kneading, as the raw material of the compound, all the components of the first soft magnetic powder, the second soft magnetic powder, and the resin composition while heating. The temperature of the raw material during kneading was 130°C at maximum. The total content of a metal filler (the first soft magnetic powder and the second soft magnetic powder) in the compound was adjusted to 95.5% by mass. In other words, the total content of the resin composition in the compound was adjusted to 4.5% by mass. A ratio (M1/(M1 + M2) described above) of the mass of the first soft magnetic powder to the metal filler was adjusted to 0.82. In other words, a ratio (M2/(M1 + M2) described above) of the mass of the second soft magnetic powder to the metal filler was adjusted to 0.18.

### <Measurement of Bending Strength>

A sample was obtained by transfer molding of the compound of Example 1 at 175°C, and post curing (heating at 175°C for 5.5 hours) subsequent to the transfer molding. A pressure applied to the compound during the transfer molding was 13.5 MPa. The sample was in the shape of a rectangular parallelepiped. The dimension of the sample was Vertical Width of 80 mm × Horizontal Width of 10 mm × Thickness of 3.0 mm. By using an autograph AGS-500A, manufactured by SHIMADZU CORPORATION, a three-point support-type bending test was implemented. In the bending test, one surface of the sample was supported by two support points F disposed at an interval of 64 mm. A load W was applied to the center position between two support points F on the other surface of the sample. A load when the sample was damaged was measured as a bending strength (Unit: MPa). The bending strength of Example 1 measured at a room temperature in the atmosphere is shown in Table 1 described below. The bending strength of Example 1 measured at a high temperature (250°C) in the atmosphere is shown in Table 1 described below.

The following pressure cooker test (PCT) was implemented. In PCT, the sample was left to stand in an airtight container containing moisture vapor for 20 hours. The temperature in the airtight container was 121°C, and the humidity in the airtight container was 100%RH. After PCT, the bending strength of the sample at a room temperature in the atmosphere was measured. The bending strength of Example 1 measured after PCT is shown in Table 1 described below.

It is preferable that the bending strength measured at a room temperature before PCT is 100 MPa or more. In Table 1, "A" described in the section "Room temperature" indicates that the bending strength measured at a room temperature before PCT is 100 MPa or more. In Table 1, "B" described in the section "Room temperature" indicates that the bending strength measured at a room temperature before PCT is less than 100 MPa.

It is preferable that the bending strength measured at a high temperature (250°C) before PCT is 8 MPa or more. In Table 1, "A" described in the section "High temperature" indicates that the bending strength measured at a high temperature before PCT is 8 MPa or more. In Table 1, "B" described in the section "High temperature" indicates that the bending strength measured at a high temperature before PCT is less than 8 MPa.

It is preferable that the bending strength measured at a room temperature in the atmosphere after PCT is 80 MPa or more. In Table 1, "A" described in the section "After PCT" indicates that the bending strength measured after PCT is 80 MPa or more. In Table 1, "B" described in the section "after PCT" indicates that the bending strength measured after PCT is less than 80 MPa.

### <Measurement of Dielectric Withstanding Voltage>

A test piece was obtained by the transfer molding of the compound of Example 1 at 175°C, and the post curing (heating at 175°C for 5.5 hours) subsequent to the transfer molding. A pressure applied to the compound during the transfer molding was 13.5 MPa. The test piece was in the shape of a column. The dimension of the test piece was a diameter of 50 mm × Thickness of 2 mm. In the following test, a voltage was applied between a pair of stainless steel electrodes provided on the test piece by using a sourcemeter. The current in the test piece was continuously measured while continuously increasing the voltage. Then, a voltage (an insulation breakdown voltage) when the current passing through the test piece exceeded 10 mA was read out. The test described above was repeated a total of 14 times by the same method except that the position of the electrode was different. The central value of the insulation breakdown voltage read out in the fourteenth test is defined as the dielectric withstanding voltage (Unit: V/mm) of the test piece. As the sourcemeter, a high-voltage dielectric characteristic evaluation apparatus, manufactured by Yamayo Tester Co., Ltd., was used. The dielectric withstanding voltage of Example 1 is shown in Table 1 described below.

It is preferable that the dielectric withstanding voltage is 200 V/mm or more. In Table 1, "A" described in the section "Dielectric withstanding voltage" indicates that the dielectric withstanding voltage is 200 V/mm or more. In Table 1, "B" described in the section "Dielectric withstanding voltage" indicates that the dielectric withstanding voltage is less than 200 V/mm.

### <Measurement of Relative Magnetic Permeability>

A toroidal molded body was obtained by the transfer molding of the compound of Example 1 at 175°C, and the post curing (heating at 175°C for 5.5 hours) subsequent to the transfer molding. A pressure applied to the compound during the transfer molding was 6.9 MPa. The dimension of the molded body was Outer Diameter of 20 mm × Inner Diameter of 12 mm × Thickness of 2 mm. Primary winding was wound around the molded body by 5 turns, and secondary winding was wound around the molded body by 5 turns. The relative magnetic permeability of the sample prepared by the method described above was measured. In the measurement of the relative magnetic permeability, a B-H analyzer (SY-8258), manufactured by IWATSU ELECTRIC CO., LTD., was used. A frequency when measuring the relative magnetic permeability was 1 MHz. The relative magnetic permeability of Example 1 is shown in Table 1 described below.

It is preferable that the relative magnetic permeability is 23 or more. In Table 1, "A" described in the section "Relative magnetic permeability" indicates that the relative magnetic permeability is 23 or more. In Table 1, "B" described in the section "Relative magnetic permeability" indicates that the relative magnetic permeability is less than 23.

### <Measurement of Spiral Flow>

The compound was accommodated in a transfer molding machine provided with a metallic mold. The spiral flow (Unit: cm) of the compound was measured at a metallic mold temperature of 175°C and an injection pressure of 6.9 MPa for a molding time of 120 seconds. The spiral flow is a length that the compound flows into a groove formed in the metallic mold. That is, the spiral flow is the fluid distance of the softened or liquefied compound. The groove into which the compound flows is in the shape of a spiral curve (a spiral of Archimedes). As the compound is likely to be fluid, the spiral flow increases. As the transfer molding machine, a 100 KN transfer molding machine (PZ-10 type), manufactured by Kodaira Seisakusho Co., Ltd., was used. As the metallic mold, a metallic mold based on ASTM D3123 was used. The spiral flow of Example 1 is shown in Table 1 described below.

### <Measurement of Lowest Melt Viscosity>

The lowest melt viscosity of the compound of Example 1 at 175°C was measured using a viscometer. As the viscometer, CFT-100 (a flow tester), manufactured by SHIMADZU CORPORATION, was used. The lowest melt viscosity of Example 1 is shown in Table 1 described below.

### (Example 2)

As with Example 1, a first soft magnetic powder of Example 2 was prepared by the wet method using "6B2" as the raw material powder. Here, in the wet method of Example 2, the thickness of the insulating coating film was adjusted to 20 nm. The first soft magnetic powder of Example 2 was analyzed by the same method as that in Example 1. Even in Example 2, the result of the analysis by TEM and EDX was approximately coincident with the result of the analysis by XPS. The results of the analysis of Example 2 were as follows.

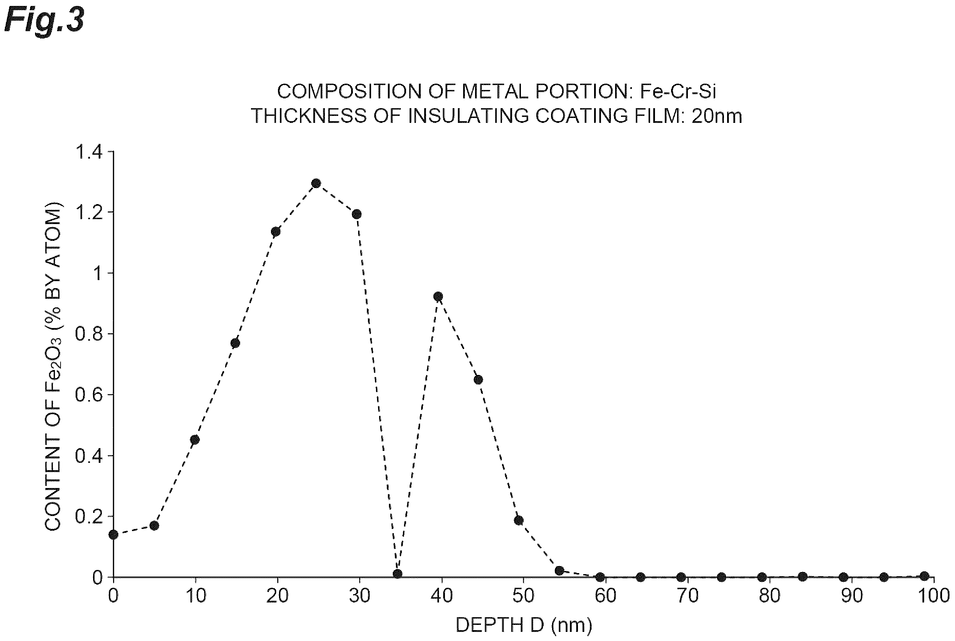

FIG. 3 illustrates the distribution of the content of Fe₂O₃ in the surface region of first soft magnetic particles of Example 2. The minimum value of the content Fe₂O₃ in the surface region of Example 2 was approximately 0.000% by atom. The maximum value of the content of Fe₂O₃ in the surface region of Example 2 was approximately 1.295% by atom. The content (the minimum value) of SiO₂ in the surface region of Example 2 was 7.99% by atom.

The first soft magnetic particles of Example 2 consisted of a metal portion, and an insulating coating film directly covering the entire metal portion.

The metal portion of Example 2 contained a soft magnetic alloy consisting of iron, chromium, and silicon.

The main component (a component other than the detected Fe₂O₃) of the insulating coating film of Example 2 was SiO₂. SiO₂ that is the main component, and a slight amount of Fe₂O₃ were mixed in the insulating coating film of Example 2.

A compound of Example 2 was prepared by the same method as that in Example 1 except for the composition and the thickness of the insulating coating film of the first soft magnetic particles. Measurement using the compound of Example 2 was implemented by the same method as that in Example 1. The measurement results of Example 2 are shown in Table 1 described below.

### (Example 3)

The total content of a metal filler (a first soft magnetic powder and a second soft magnetic powder) in a compound of Example 3 was adjusted to 96.0% by mass. In other words, the total content of a resin composition in the compound of Example 3 was adjusted to 4.0% by mass.

The compound of Example 3 was prepared by the same method as that in Example 1 except for the above respects. Measurement using the compound of Example 3 was implemented by the same method as that in Example 1. The measurement results of Example 3 are shown in Table 1 described below.

### (Comparative Example 1)

As a first soft magnetic powder of Comparative Example 1, "9A4", manufactured by EPSON ATMIX Corporation, was used. "9A4" is a powder of a soft magnetic alloy consisting of Fe and Si, and does not contain Cr. The average particle diameter of "9A4" was 24 µm. In Comparative Example 1, an insulating coating film of first soft magnetic particles was not formed. The particle diameter of the first soft magnetic powder consisting of "9A4" was even.

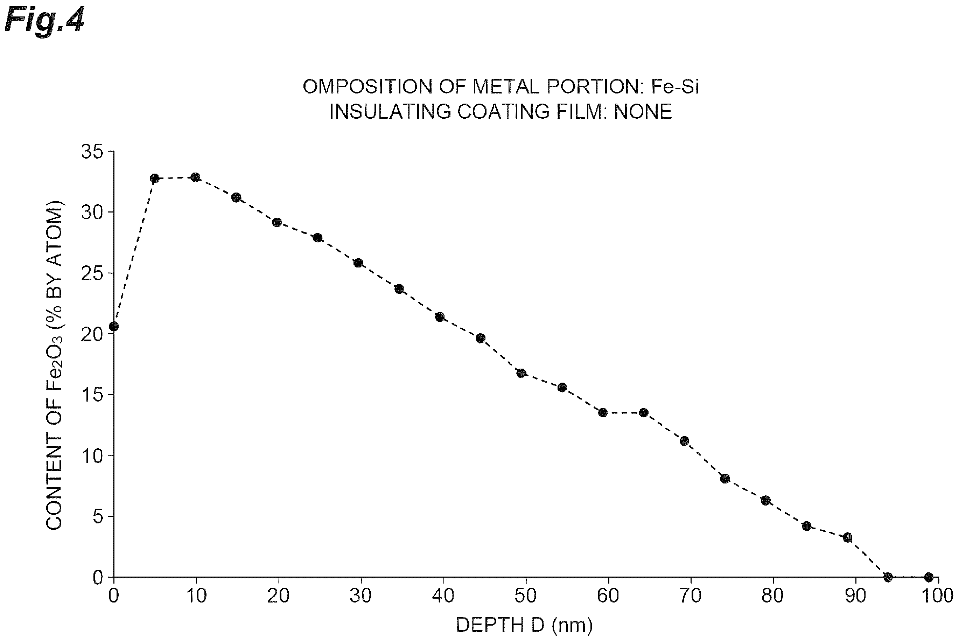

The first soft magnetic powder of Comparative Example 1 was analyzed by the same method as that in Example 1. FIG. 4 illustrates the distribution of the content of Fe₂O₃ in the surface region of the first soft magnetic particles of Comparative Example 1. The maximum value of the content of Fe₂O₃ in the surface region of Comparative Example 1 was considerably greater than 10% by atom. The detected Fe₂O₃ in Comparative Example 1 is derived from a native oxide formed on the surface of the first soft magnetic particles.

A compound of Comparative Example 1 was prepared by the same method as that in Example 1 except for the composition of the first soft magnetic powder. Measurement using the compound of Comparative Example 1 was implemented by the same method as that in Example 1. The measurement results of Comparative Example 1 are shown in Table 1 described below.

### (Comparative Example 2)

As the raw material powder of a first soft magnetic powder of Comparative Example 2, "9A4" described above was used. By treating the surface of each of soft magnetic alloy particles composing the raw material powder with an aqueous solution of a phosphoric acid, an insulating coating film consisting of iron oxide and a phosphate was formed on the surface of each of the soft magnetic alloy particles. That is, first soft magnetic particles of Comparative Example 2 were composed of a metal portion of an alloy consisting of Fe and Si, and an insulating coating film consisting of iron oxide and a phosphate. The particle diameter of the first soft magnetic powder of Comparative Example 2 was even.

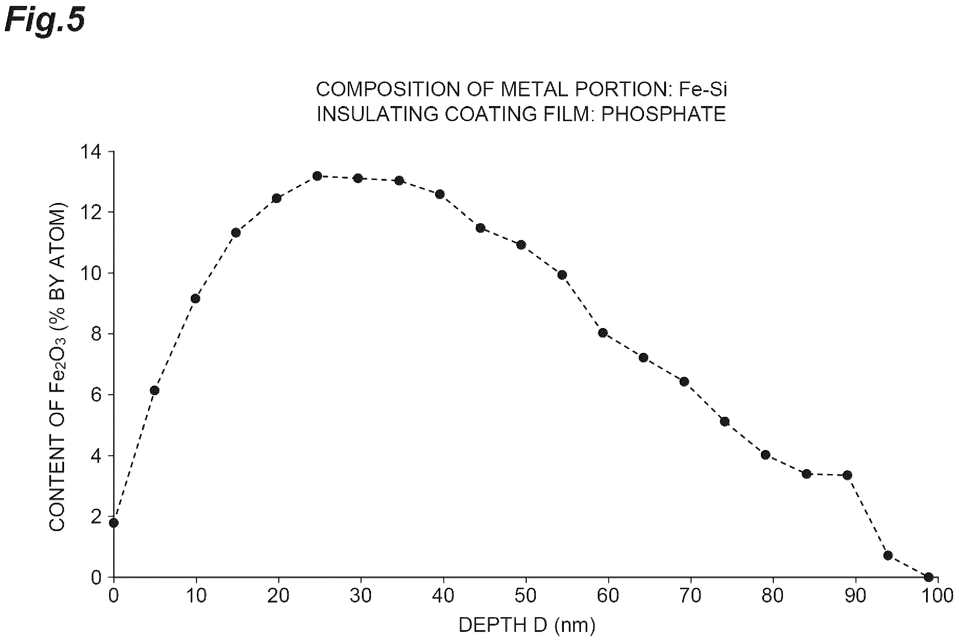

The first soft magnetic powder of Comparative Example 2 was analyzed by the same method as that in Example 1. FIG. 5 illustrates the distribution of the content of Fe₂O₃ in the surface region of the first soft magnetic particles of Comparative Example 2. The maximum value of the content of Fe₂O₃ in the surface region of Comparative Example 2 was greater than 10% by atom.

A compound of Comparative Example 2 was prepared by the same method as that in Example 1 except for the composition of the first soft magnetic powder. Measurement using the compound of Comparative Example 2 was implemented by the same method as that in Example 1. The measurement results of Comparative Example 2 are shown in Table 1 described below.

### (Comparative Example 3)

As the raw material powder of a first soft magnetic powder of Comparative Example 3, "9A4" described above was used. As with Example 1 except for the composition of the raw material powder, the formation of an insulating coating film was attempted by the wet method. However, since the raw material powder of Comparative Example 3 did not contain Cr, the insulating coating film was not formed on the surface of each of soft magnetic alloy particles composing the raw material powder.

A compound of Comparative Example 3 was prepared by the same method as that in Example 1 except for the composition of the first soft magnetic powder. Measurement using the compound of Comparative Example 3 was implemented by the same method as that in Example 1. The measurement results of Comparative Example 3 are shown in Table 1 described below.

### (Comparative Example 4)

As a first soft magnetic powder of Comparative Example 4, "6B2" described above was used without being worked. That is, in Comparative Example 4, an insulating coating film of first soft magnetic particles was not formed. The particle diameter of the first soft magnetic powder consisting of "6B2" was even.

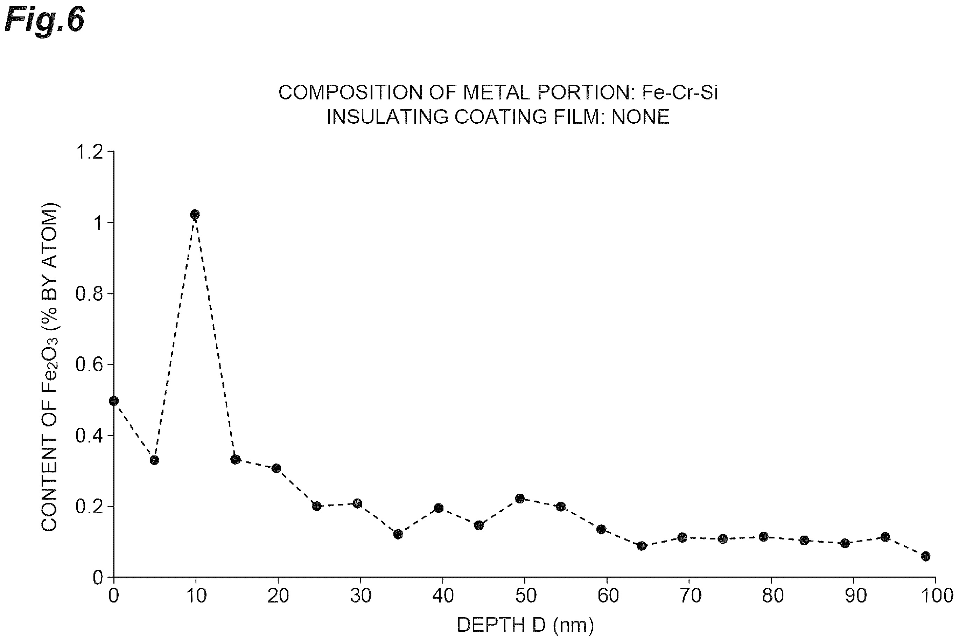

The first soft magnetic powder of Comparative Example 4 was analyzed by the same method as that in Example 1. FIG. 6 illustrates the distribution of the content of Fe₂O₃ in the surface region of the first soft magnetic particles of Comparative Example 4.

A compound of Comparative Example 4 was prepared by the same method as that in Example 1 except for the composition of the first soft magnetic powder. Measurement using the compound of Comparative Example 4 was implemented by the same method as that in Example 1. The measurement results of Comparative Example 4 are shown in Table 1 described below.

### (Comparative Example 5)

As the raw material powder of a first soft magnetic powder of Comparative Example 5, "6B2" described above was used. By treating the surface of each of soft magnetic alloy particles composing the raw material powder with an aqueous solution of a phosphoric acid, an insulating coating film consisting of iron oxide and a phosphate was formed on the surface of each of the soft magnetic alloy particles. That is, first soft magnetic particles of Comparative Example 5 were composed of a metal portion of an alloy consisting of Fe, Cr, and Si, and an insulating coating film consisting of iron oxide and a phosphate. The particle diameter of the first soft magnetic powder of Comparative Example 5 was even.

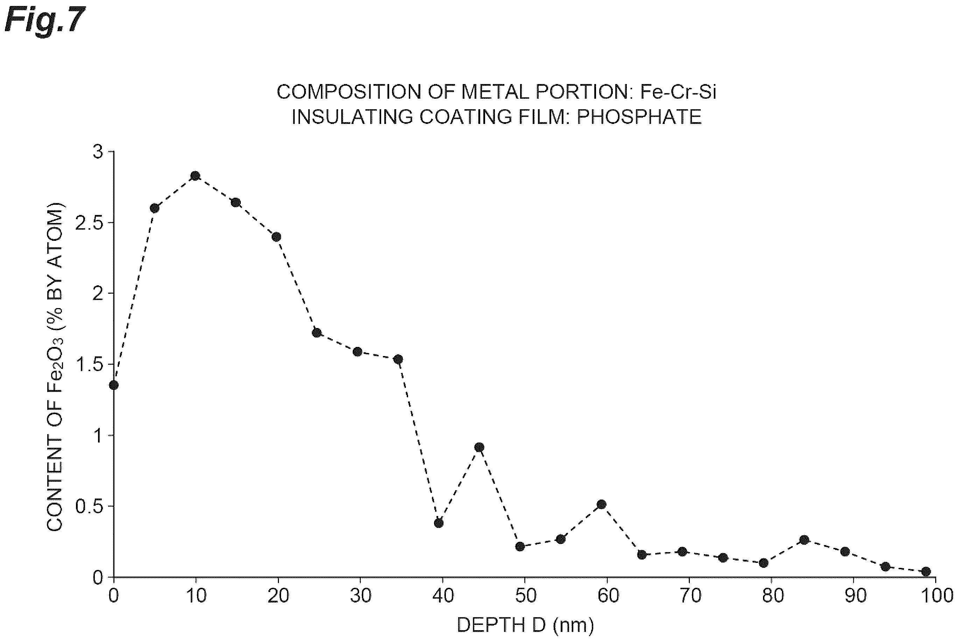

The first soft magnetic powder of Comparative Example 5 was analyzed by the same method as that in Example 1. FIG. 7 illustrates the distribution of the content in Fe₂O₃ in the surface region of the first soft magnetic particles of Comparative Example 5.

A compound of Comparative Example 5 was prepared by the same method as that in Example 1 except for the composition of the first soft magnetic powder. Measurement using the compound of Comparative Example 5 was implemented by the same method as that in Example 1. The measurement results of Comparative Example 5 are shown in Table 1 described below.

**[Table 1]**

| Table 1 | | Comparative Example 1 | Comparative Example 2 | Comparative Example 3 | Comparative Example 4 | Comparative Example 5 | Example 1 | Example 2 | Example 3 |
|---|---|---|---|---|---|---|---|---|---|
| Total content of metal filler (Unit: % by mass) | | 95.5 | 95.5 | 95.5 | 95.5 | 95.5 | 95.5 | 95.5 | 96.0 |
| First soft magnetic powder | Metal portion | Fe-Si (9A4) | Fe-Si (9A4) | Fe-Si (9A4) | Fe-Cr-Si (6B2) | Fe-Cr-Si (6B2) | Fe-Cr-Si (6B2) | Fe-Cr-Si (6B2) | Fe-Cr-Si (6B2) |
| | Insulating coating film | None | Phosphate | None | None | Phosphate | Silica | Silica | Silica |
| | Thickness of insulating coating film (Unit: mm) | 0 | 10 | 0 | 0 | 10 | 40 | 20 | 40 |
| Bending strength (Unit: MPa) | Room temperature | 77 | 88 | 98 | 98 | 94 | 116 | 109 | 141 |
| | | B | B | B | B | B | A | A | A |
| | High temperature | 5 | 5 | 5 | 5 | 6 | 11 | 13 | 13 |
| | | B | B | B | B | B | A | A | A |
| | After PCT | 52 | 36 | 63 | 82 | 30 | 101 | 101 | 105 |
| | | B | B | B | A | B | A | A | A |
| Dielectric withstanding voltage (Unit: V/mm) | | 196 | 343 | 154 | 83 | 109 | 394 | 236 | 358 |
| | | B | A | B | B | B | A | A | A |
| Relative magnetic permeability (Unit: none) | | 22.1 | 21.0 | 21.0 | 27.9 | 26.8 | 23.9 | 24.8 | 25.7 |
| | | B | B | B | A | A | A | A | A |
| Spiral flow (Unit: cm) | | 57 | 71 | 66 | 66 | 81 | 67 | 71 | 65 |
| Lowest melt viscosity (Unit: Pa·s) | | 114 | 39 | 48 | 48 | 73 | 57 | 52 | 185 |

### (Measurement of Volume Resistivity of Green Compact)

A green compact 1 was formed by compressing the raw material powder (6B2) used in Example 1 at a pressure shown in Table 2 described below without implementing the wet method for forming the insulating coating film. The volume resistivity (Unit: Ω·cm) of the green compact 1 formed at each pressure was measured. The volume resistivity of the green compact 1 formed at each pressure is shown in Table 2 described below.

A green compact 2 was formed by compressing the first soft magnetic powder of Example 1 at a pressure shown in Table 2 described below. The volume resistivity of the green compact 2 formed at each pressure was measured. The volume resistivity of the green compact 2 formed at each pressure is shown in Table 2 described below.

In the measurement of the volume resistivity, a measuring device (Product Number: 5451), manufactured by ADC CORPORATION, was used.

**[Table 2]**

| Table 2 | | |
|---|---|---|
| Pressure (MPa) | Volume resistivity (Ω·cm) | |
| | Green compact 1 | Green compact 2 |
| 13 | 5.60E+04 | 4.40E+10 |
| 26 | 4.40E+04 | 3.30E+10 |
| 38 | 3.90E+04 | 2.90E+10 |
| 50 | 1.20+04 | 2.40E+10 |
| 64 | 1.20+04 | 1.50E+10 |

### Industrial Applicability

For example, the compound according to one aspect of the present invention may be used for a coil component, an electromagnetic shield, or a semiconductor package.

### Reference Signs List

1: first soft magnetic particles (first soft magnetic powder), 2: second soft magnetic particles (second soft magnetic powder), 3: resin composition, 4A, 4B: metal portion, 5A, 5B: insulating coating film, 10: compound.

## Claims

1. A compound comprising:
a first soft magnetic powder;
a second soft magnetic powder; and
a resin composition,
wherein the resin composition contains a thermosetting resin,
a particle diameter of the first soft magnetic powder is greater than a particle diameter of the second soft magnetic powder,
first soft magnetic particles composing the first soft magnetic powder include a metal portion, and an insulating coating film directly covering the metal portion,
at least a part of the metal portion is a soft magnetic alloy containing iron, chromium, and silicon,
the insulating coating film contains SiO₂, and
a content of Fe₂O₃ in a surface region of the first soft magnetic particles where a depth from an outermost surface of the first soft magnetic particles is 100 nm or less is 0% by atom or more and 10% by atom or less.

2. The compound according to claim 1,
wherein a lowest melt viscosity of the compound at 175°C is 10 Pa·s or more and 250 Pa·s or less, and
a spiral flow of the compound at 175°C is 30 cm or more and 200 cm or less.

3. The compound according to claim 1 or 2,
wherein the compound fluidized by heating is molded.

4. The compound according to claim 1 or 2,
wherein a thickness of the insulating coating film is 10 nm or more and 200 nm or less.

5. The compound according to claim 1 or 2,
wherein the insulating coating film further contains Fe₂O₃, and
a maximum value of the content of Fe₂O₃ in the surface region is greater than 0% by atom and 10% by atom or less.

6. The compound according to claim 5,
wherein SiO₂ and Fe₂O₃ are mixed in the insulating coating film.

7. The compound according to claim 1 or 2,
wherein the insulating coating film does not contain phosphorus.

8. The compound according to claim 1 or 2,
wherein a total content of the first soft magnetic powder and the second soft magnetic powder in the whole of the compound is 94% by mass or more and 98% by mass or less.

9. The compound according to claim 1 or 2,
wherein the resin composition contains an epoxy resin, a curing agent, and a coupling agent.

10. The compound according to claim 1 or 2,
wherein a content of SiO₂ in the surface region is greater than the content of Fe₂O₃ in the surface region.

11. The compound according to claim 1 or 2,
wherein the compound is used for a magnetic core of a coil.

12. The compound according to claim 1 or 2,
wherein the compound is a sealing material also serving as an electromagnetic shielding material.

13. A molded body comprising
the compound according to claim 1 or 2.

14. A cured product of the compound according to claim 1 or 2.
